# EUROPÄISCHE PATENTSCHRIFT

(11) **EP 0 460 520 B1**
(45) Veröffentlichungstag und Bekanntmachung des Hinweises auf die Patenterteilung: **30.08.1995**
(21) Anmeldenummer: 91108774.0
(22) Anmeldetag: 29.05.1991
(51) Int. Cl.: H04N 5/76

(54) **Einrichtung zur Programmierung eines Videorecorders unter Verwendung einer Fernsehtextprogrammvorschauseite**
Programming device for video recorder using a videotext program schedule page
Dispositif de contrôle de programme d'un magnetoscope utilisant une page de prochaines émissions de vidéotexte

(30) Priorität: 08.06.1990 DE 4018368
(43) Veröffentlichungstag der Anmeldung: 11.12.1991
(73) Patentinhaber: Grundig E.M.V. Elektro-Mechanische Versuchsanstalt Max Grundig GmbH & Co. KG, 90762 Fürth (DE)
(72) Erfinder: Raab, Frank, Grundig E.M.V., El.-Mech.Vers.anstalt, Kurgartenstrasse 37, W-8510 Fürth (DE)

(56) Entgegenhaltungen:
- DE-A- 3 533 707
- DE-A- 3 641 864
- DE-A- 3 742 468
- US-A- 4 755 883
- US-A- 4 866 542
- US-A- 4 908 707

## Beschreibung

Die Erfindung betrifft eine Einrichtung zur Programmierung eines Videorecorders mit den im Oberbegriff der nebengeordneten Ansprüche 1 und 2 angegebenen Merkmalen.

Aus der Zeitschrift "Rundfunktechnische Mitteilungen" Jahrg. 30 (1986), H. 5, S. 223-229, ist bereits eine Einrichtung zur Programmierung eines Videorecorders unter Verwendung einer Fernsehtext-Programmvorschauseite bekannt. Bei dieser bekannten Einrichtung wählt der Benutzer mit der Fernbedienung eine eine Programmvorschau enthaltende Fernsehtextseite an, deren Inhalt auf dem Bildschirm eines an den Videorecorder angeschlossenen Fernsehempfängers dargestellt wird. Die dargestellte Seite enthält im wesentlichen den Namen der Sendeanstalt, das Sendedatum, die vorgesehenen Sendezeiten mehrerer Fernsehsendungen, ggfs. sog. VPS-Zeiten, die sich aufgrund von kurzfristigen Programmänderungen von den vorgesehenen Sendezeiten unterscheiden, sowie die Titel der einzelnen Fernsehsendungen. Der bekannte Videorecorder wird zur automatischen Aufzeichnung einer der dargestellten Fernsehsendungen dadurch programmiert, daß mittels eines Cursors die gewünschte Sendung angewählt wird und durch Betätigung einer Übernahmetaste die der angewählten Sendung zugehörigen Programmierdaten aus der Fernsehtextseite extrahiert und in einem Programmwunschspeicher des Videorecorders abgelegt werden. Die abgespeicherten Programmierdaten enthalten dabei im wesentlichen das Sendedatum, Informationen über die Programmquelle, die angekündigte Anfangszeit der Sendung, eine VPS-Zeit, den Titel der Sendung und die Endzeit.

Ein Nachteil der bekannten Einrichtung besteht darin, daß dann, wenn die Programmierung des Videorecorders während der Zeit erfolgen soll, während der beispielsweise ein anderes Familienmitglied eine laufende Fernsehsendung am Bildschirm des an den Videorecorder angeschlossenen Fernsehempfängers verfolgt, die Wiedergabe der laufenden Fernsehsendung unterbrochen werden muß, um eine Videorecorderprogrammierung unter Verwendung einer Fernsehtext-Programmvorschauseite durchführen zu können.

Die Aufgabe der Erfindung besteht darin, eine Einrichtung zur Programmierung eines Videorecorders mit den im Oberbegriff des Anspruchs 1 bzw. 2 angegebenen Merkmalen derart weiterzubilden, daß der vorgenannte Nachteil nicht mehr auftritt.

Diese Aufgabe wird bei einer Einrichtung mit den im Oberbegriff des Anspruchs 1 bzw. 2 angegebenen Merkmalen durch die im kennzeichnenden Teil des Anspruchs 1 bzw. 2 angegebenen Merkmale gelöst. Vorteilhafte Ausgestaltungen der Erfindung ergeben sich aus den Unteransprüchen.

Die Vorteile der Erfindung bestehen insbesondere darin, daß die Vorteile einer Videorecorderprogrammierung unter Verwendung einer Fernsehtext-Programmvorschauseite auch dann genutzt werden können, wenn auf dem Bildschirm des an den Videorecorder angeschlossenen Fernsehempfängers gerade ein laufendes Fernsehprogramm betrachtet wird. Weitere Vorteile der Erfindung ergeben sich aus der Erläuterung eines Ausführungsbeispiels anhand der Figuren.

Es zeigen:
- Figur 1 ein Blockschaltbild eines Videorecorders zur Veranschaulichung der Wirkungsweise der beanspruchten Einrichtung, und
- Figuren 2a, 2b, 2c und 2d bevorzugte Ausgestaltungen der bei der Programmierung des Videorecorders verwendeten Anzeigeeinheit.

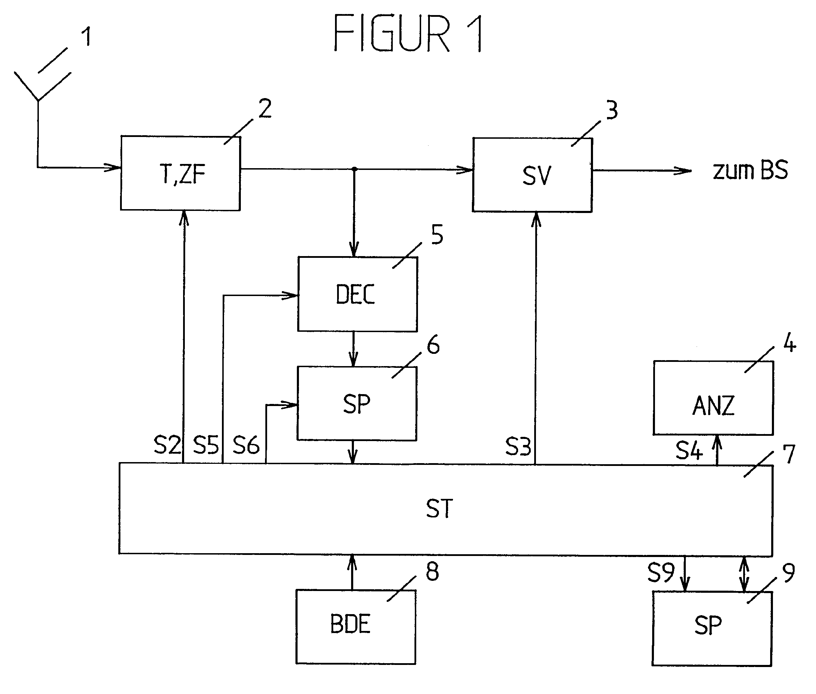

Die Figur 1 zeigt ein Blockschaltbild eines Videorecorders, welcher ein mit einer Antenne 1 verbundenes Empfangsteil 2, eine Signalverarbeitungsschaltung 3, eine Anzeigeeinheit 4, einen Fernsehtextdecoder 5, einen Fernsehtextseitenspeicher 6, eine Steuerschaltung 7, eine Bedieneinheit 8 und einen Programmwunschspeicher 9 aufweist.

Die Steuerschaltung 7, die durch einen Mikrocomputer realisiert ist, dient zur Steuerung der Arbeitsweise der vorgenannten Schaltungen 2, 3, 4, 5, 6 und 9, was durch die Steuerleitungen S2, S3, S4, S5, S6 und S9 angedeutet ist.

Das von der Antenne 1 empfangene hochfrequente Videosignal wird dem Empfangsteil 2 zugeführt, welches einen Tuner und einen ZF-Verstärker aufweist. Am Ausgang des Empfangsteils 2 steht ein FBAS-Signal zur Verfügung. Dieses wird in der Signalverarbeitungsschaltung 3 in ein Komponentensignal, beispielsweise ein RGB-Signal, umgewandelt. Das am Ausgang der Signalverarbeitungsschaltung 3 erhaltene Komponentensignal wird - ggfs. nach Rückumwandlung in ein FBAS-Signal - einem an den Videorecorder angeschlossenen Fernsehempfänger zugeführt und auf dessen Bildschirm dargestellt,
Ferner werden aus dem am Ausgang des Empfangsteils 2 zur Verfügung stehenden FBAS-Signal im Fernsehtextdecoder 5 die in den vertikalen Austastlücken übertragenen Fernsehtextsignale abgetrennt und die einer Fernsehtextseite zugehörigen Fernsehtextdaten in einem Fernsehtextseitenspeicher 6 zwischengespeichert.

Die Programmierung des Videorecorders zur Aufzeichnung einer gewünschten Fernsehsendung geschieht wie folgt: Mittels der Bedieneinheit 8 wird zunächst derjenige Videorecorderkanal, in welchem eine die gewünschte Fernsehsendung enthaltende Programmvorschauseite übertragen wird, und dann die Programmvorschauseite selbst angewählt. Dies bewirkt eine Zwischenspeicherung der Fernsehtextdaten der genannten Programmvorschauseite im Fernsehtextseitenspeicher 6.

Anschließend adressiert die Steuerschaltung 7 den Fernsehtextseitenspeicher 6 derart, daß automatisch zunächst die Fernsehtextdaten der ersten auf der Programmvorschauseite enthaltenen Fernsehsendung ausgelesen und auf der Anzeige 4 optisch hervorgehoben dargestellt werden. Bei diesen Fernsehtextdaten, die auf der Anzeige 4 zur optischen Hervorhebung vorzugsweise blinkend dargestellt werden, handelt es sich um die Bezeichnung der Sendeanstalt, das Sendedatum, die Anfangszeit und ggfs. die Endzeit und der Titel der Sendung. Die blinkende Anzeige der Fernsehtextdaten der ersten, auf der Programmvorschauseite enthaltenen Fernsehsendung bleibt für eine Zeitdauer von beispielsweise 2 - 3 Sekunden erhalten. Dann adressiert die Steuerschaltung 7 den Fernsehtextseitenspeicher 6 derart, daß automatisch die Fernsehtextdaten der zweiten, auf der Programmvorschauseite enthaltenen Fernsehsendung ausgelesen und für die Zeitdauer von 2 - 3 Sekunden blinkend auf der Anzeige 4 dargestellt werden, usw.

Wird während des Zeitraumes, in welchem die Fernsehtextdaten der gewünschten Fernsehsendung blinkend auf der Anzeige 4 dargestellt werden, eine auf der Bedieneinheit 8 angeordnete Übernahmetaste betätigt, dann werden die genannten Fernsehtextdaten und ggfs. weitere zur automatischen Aufzeichnung notwendige, in der Programmvorschauseite enthaltene und nicht dargestellte Informationen im Programmwunschspeicher 9 abgelegt. Damit ist der Videorecorder zur Aufzeichnung der gewünschten Fernsehsendung programmiert.

Gemäß einer anderen Ausführungsform der Erfindung adressiert die Steuerschaltung 7 nach der Zwischenspeicherung der Fernsehtextdaten der angewählten Programmvorschauseite den Fernsehtextseitenspeicher 8 derart, daß die Fernsehtextdaten der ersten auf der Programmvorschauseite enthaltenen Fernsehsendung ausgelesen und auf der Anzeige 4 blinkend dargestellt werden. Diese blinkende Darstellung der Fernsehtextdaten der ersten Fernsehsendung bleibt solange erhalten, bis eine auf der Bedieneinheit 8 angeordnete Weiterschalttaste betätigt wird. Daraufhin adressiert die Steuerschaltung 7 den Fernsehtextseitenspeicher 6 derart, daß die Fernsehtextdaten der zweiten, auf der Programmvorschauseite enthaltenen Fernsehsendung ausgelesen und auf der Anzeige 4 dargestellt werden, usw. Bei dieser Ausführungsform hat folglich der Benutzer die Möglichkeit, die Geschwindigkeit, mit der die Fernsehtextdaten der einzelnen auf der Programmvorschauseite enthaltenden Fernsehsendungen nacheinander dargestellt werden, selbst vorzugeben.

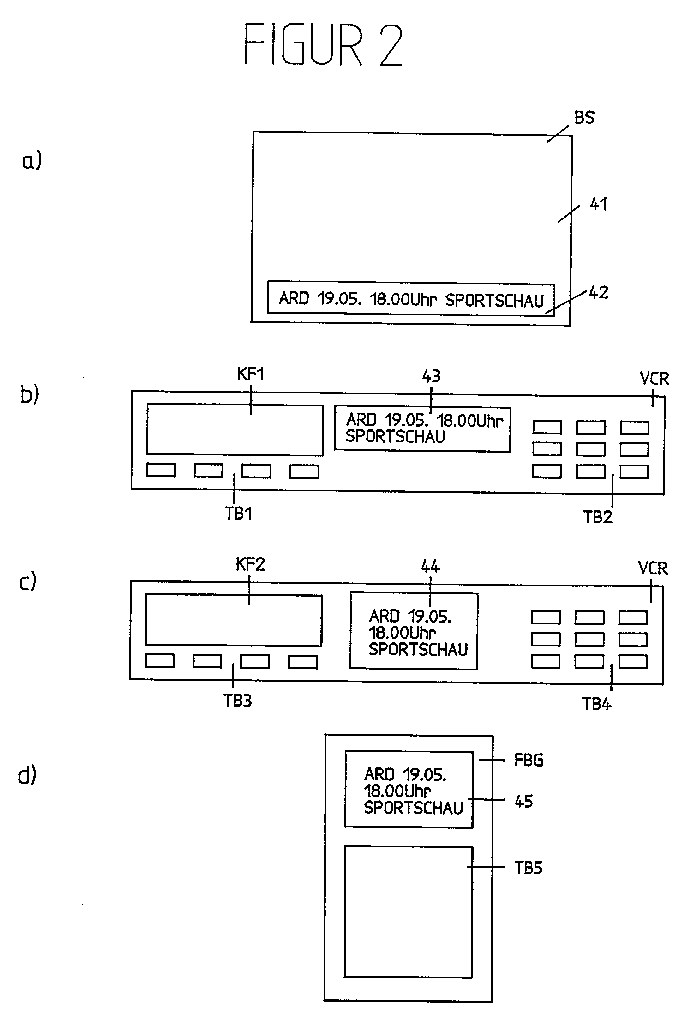

Im folgenden werden anhand der Figuren 2a, 2b, 2c und 2d bevorzugte Ausgestaltungen der bei der Programmierung des Videorecorders verwendeten Anzeigeeinheit 4 beschrieben.

Bei der in Figur 2a gezeigten bevorzugten Ausgestaltung erfolgt die blinkende Darstellung der Fernsehtextdaten, die die Sendeanstalt, den Sendetag, die Anfangszeit und den Titel beschreiben, in einer am unteren Rand eines an den Videorecorder angeschlossenen Fernsehempfängerbildschirms BS eingeblendeten Schriftzeile 42. Der Vorteil dieser Ausgestaltung besteht insbesondere darin, daß die Zeichengröße der in der Schriftzeile enthaltenen alphanumerischen Zeichen so groß gewählt werden kann, daß die Videorecorderprogrammierung beispielsweise bequem vom Fernsehsessel aus unter Verwendung eines Fernbedienungsgebers erfolgen kann. Die übrige Fläche 41 des Bildschirms kann zur Wiedergabe einer laufenden Fernsehsendung genutzt werden, so daß es zur Programmierung des Videorecorders unter Verwendung einer Fernsehtext-Programmvorschauseite nicht notwendig ist, eine laufende Fernsehsendung zu unterbrechen.

Bei der in Figur 2b gezeigten bevorzugten Ausgestaltung erfolgt die blinkende Darstellung der Fernsehtextdaten, die die Sendeanstalt, den Sendetag, die Anfangszeit und den Titel beschreiben, auf einem in das Gehäuse des Videorecorders VCR integrierten alphanumerischen Display 43. Dieses ist neben einem Kassettenfach KF1 sowie Tastenblöcken TB1 und TB2, welche die bei Videorecordern allgemein üblichen Funktions- und Zifferntasten enthalten, auf der Frontseite des Videorecorders angeordnet.

Bei der in Figur 2c gezeigten bevorzugten Ausgestaltung erfolgt die blinkende Darstellung der Fernsehtextdaten, die die Sendeanstalt, den Sendetag, die Anfangszeit und den Titel beschreiben, auf einem am Gehäuse des Videorecordes VCR befestigten Flüssigkristallbildschirm 44. Dieser ist neben einem Kassettenfach KF2 sowie Tastenblöcken TB3 und TB4, welche die bei Videorecordern allgemein üblichen Funktions- und Zifferntasten enthalten, auf der Frontseite des Videorecorders angeordnet.

Bei der in Figur 2d gezeigten bevorzugten Ausgestaltung erfolgt die blinkende Darstellung der Fernsehtextdaten, die die Sendeanstalt, den Sendetag, die Anfangszeit und den Titel beschreiben, auf einem in das Gehäuse des Fernbedienungsgebers FBG des Videorecorders integrierten alphanumerischen Displays 45. Der Fernbedienungsgeber weist neben dem alphanumerischen Display 45 noch einen Tastenblock TB5 auf, welcher die bei Fernbedienungen allgemein üblichen Funktions- und Zifferntasten enthält. Um die genannten Fernsehtextdaten vom Videorecorder zum Fernbedienungsgeber FBG übertragen zu können, weist der Videorecorder einen nicht gezeichneten, mit der Steuerschaltung 7 verbundenen Infrarotsender auf, von welchem aus die Fernsehtextdaten zu einem Infrarotempfänger des Fernbedienungsgebers FBG übertragen werden.

Die Vorteile der in den Figuren 2b, 2c und 2d gezeigten Ausgestaltungen bestehen insbesondere darin, daß die Programmierung des Videorecorders unter Verwendung einer Fernsehtext-Programmvorschauseite völlig unabhängig vom Bildschirm des an den Videorecorder angeschlossenen Fernsehempfängers erfolgen kann. Es ist dabei unerheblich, ob am Bildschirm des Fernsehempfängers während des Programmiervorganges eine laufende Fernsehsendung betrachtet wird oder ob der Fernsehempfänger während dieser Zeit ausgeschaltet ist.

Eine weitere vorteilhafte Ausgestaltung der Erfindung besteht darin, als Fernsehtextseitenspeicher einen Mehrseitenspeicher vorzusehen. In diesem Mehrseitenspeicher werden unmittelbar nach der Verbindung des Videorecorders mit einer Versorgungsspannung automatisch alle eine Programmvorschau enthaltenden Fernsehtextseiten abgespeichert. Diese Ausgestaltung hat insbesondere den Vorteil, daß der Benutzer die Seitennummer der Programmvorschauseite, die die gewünschte Sendung enthält, nicht von Hand eingeben muß, sondern sich durch Betätigung einer zu diesem Zweck vorgesehenen Taste der Bedieneinheit Schritt für Schritt durch sämtliche Programmvorschauseiten durchtasten kann.

## Patentansprüche

1. Einrichtung zur Programmierung eines Videorecorders, mit
- einer Bedieneinheit zur Eingabe von Bedienbefehlen,
- einem Fernsehtextdecoder zur Abtrennung von in einer Programmvorschauseite enthaltenen, mehreren Fernsehsendungen entsprechenden Fernsehtextdaten aus einem Fernsehsendesignal,
- einem Fernsehtextseitenspeicher zur Zwischenspeicherung der genannten Fernsehtextdaten, und
- einem Programmwunschspeicher zur Abspeicherung von Programmierdaten,
**dadurch gekennzeichnet,** daß
- eine Steuerschaltung vorgesehen ist, die aus dem Fernsehtextseitenspeicher durch entsprechende Adressenauswahl Daten derart abruft, daß die den einzelnen Fernsehsendungen entsprechenden Fernsehtextdaten automatisch und sendungsweise einzeln nacheinander ausgewählt werden, und
- die Fernsehtextdaten der jeweils aus der zwischengespeicherten Programmvorschauseite ausgewählten einzelnen Fernsehsendung für eine im Bereich mehrerer Sekunden liegenden Zeitdauer optisch hervorgehoben und ohne Unterbrechung einer laufenden Fernsehsendung auf einer Anzeigeeinheit darstellbar sind.

2. Einrichtung zur Programmierung eines Videorecorders, mit
- einer Bedieneinheit zur Eingabe von Bedienbefehlen,
- einem Fernsehtextdecoder zur Abtrennung von in einer Programmvorschauseite enthaltenen, mehreren Fernsehsendungen entsprechenden Fernsehtextdaten aus einem Fernsehsendersignal,
- einem Fernsehtextseitenspeicher zur Zwischenspeicherung der genannten Fernsehtextdaten, und
- einem Programmwunschspeicher zur Abspeicherung von Programmierdaten,
**dadurch gekennzeichnet**, daß
- eine Steuerschaltung vorgesehen ist, die aus dem Fernsehtextseitenspeicher durch entsprechende Adressenauswahl Daten derart abruft, daß die den einzelnen Fernsehsendungen entsprechenden Fernsehtextdaten sendungsweise einzeln nacheinander unter Steuerung durch die Bedieneinheit ausgewählt werden, und
- die Fernsehtextdaten der jeweils aus der zwischengespeicherten Programmvorschauseite ausgewählten einzelnen Fernsehsendung optisch hervorgehoben und ohne Unterbrechung einer laufenden Fernsehsendung auf einer Anzeigeeinheit darstellbar sind.

3. Einrichtung nach Anspruch 1 oder 2, **dadurch gekennzeichnet,** daß die Anzeigeeinheit der Bildschirm eines an den Videorecorder angeschlossenen Fernsehempfängers ist und die optisch hervorgehobene Darstellung der Fernsehtextdaten in einer in ein Fernsehbild eingeblendeten Schriftzeile am unteren Bildschirmrand erfolgt.

4. Einrichtung nach Anspruch 1 oder 2, **dadurch gekennzeichnet,** daß die Anzeigeeinheit ein in das Gehäuse des Videorecorders integriertes alphanumerisches Display ist.

5. Einrichtung nach Anspruch 1 oder 2, **dadurch gekennzeichnet,** daß die Anzeigeeinheit ein am Gehäuse des Videorecorders befestigter Flüssigkristallbildschirm ist.

6. Einrichtung nach Anspruch 1 oder 2, **dadurch gekennzeichnet,** daß die Fernsehtextdaten von einem Infrarotsender des Videorecorders zu einem Infrarotempfänger des Fernbedienungsgebers des Videorecorders übertragen und auf einem in das Gehäuse des Fernbedienungsgebers integrierten alphanumerischen Display dargestellt werden.

7. Einrichtung nach einem oder mehreren der vorhergehenden Ansprüche, **dadurch gekennzeichnet,** daß die auf der Anzeigeeinheit dargestellten Fernsehtextdaten blinkend dargestellt werden.

8. Einrichtung nach einem oder mehreren der vorhergehenden Ansprüche, **dadurch gekennzeichnet,** daß der Fernsehtextseitenspeicher ein Mehrseitenspeicher ist, in welchem nach der Verbindung des Videorecorders mit einer Versorgungsspannung automatisch alle eine Programmvorschau enthaltenden Fernsehtextseiten abgespeichert werden.

## Claims

1. Device for programming a video recorder, comprising
- a operating unit for entering the operating commands,
- a teletext decoder for separating teletext data contained in a programme preview page and corresponding to a plurality of television programmes from a television transmission signal,
- a teletext page memory for temporarily storing the said teletext data, and
- a required programme memory for storing programming data,
characterized in that
- a control circuit is provided which retrieves data from the teletext page memory by appropriate address selection in such a way that the teletext data corresponding to the individual television programmes are selected automatically and individually one after the other in order of transmission, and
- the teletext data of the individual television programme selected in each case from the temporarily stored programme preview page are visually highlighted for a time in the region of several seconds and can be displayed on a display unit without interrupting a current television programme.

2. Device for programming a video recorder, comprising
- a operating unit for entering control commands,
- a teletext decoder for separating teletext data contained in a programme preview page and corresponding to a plurality of television programmes from a television transmission signal,
- a teletext page memory for temporarily storing the said teletext data, and
- a required programme memory for storing programming data,
characterized in that
- a control circuit is provided which retrieves data from the teletext page memory by appropriate address selection in such a way that the teletext data corresponding to the individual television programmes are selected individually one after the other in order of transmission under the control of the operating unit, and
- the teletext data of the individual television programme selected in each case from the temporarily stored programme preview page are visually highlighted and can be displayed on a display unit without interrupting a current television programme.

3. Device according to Claim 1 or 2, characterized in that the display unit is the viewing screen of a television receiver connected to the video recorder and the visually highlighted display of the teletext data takes place in a text line inserted in a television picture at the lower edge of the viewing screen.

4. Device according to Claim 1 or 2, characterized in that the display unit is an alphanumerical display built into the housing of the video recorder.

5. Device according to Claim 1 or 2, characterized in that the display unit is a liquid-crystal viewing screen mounted on the housing of the video recorder.

6. Device according to Claim 1 or 2, characterized in that the teletext data are transmitted from an infrared transmitter of the video recorder to an infrared receiver of the remote controller of the video recorder and are displayed on an alphanumerical display built into the housing of the remote controller.

7. Device according to one or more of the preceding claims, characterized in that the teletext data displayed on the display unit are displayed in flashing form.

8. Device according to one or more of the preceding claims, characterized in that the teletext page memory is a multiple-page memory in which all the teletext pages containing a programme preview are automatically stored after the connection of the video recorder to a supply voltage.

## Revendications

1. Dispositif pour programmer un magnétoscope, comportant
- une unité de commande pour introduire des instructions de commande,
- un décodeur de vidéotexte pour séparer, d'un signal d'émission de télévision, les données de vidéotexte contenues dans une page d'annonce de programme et correspondant à plusieurs émissions de télévision,
- une mémoire de pages de vidéotexte pour mémoriser temporairement les données indiquées de vidéotexte, et
- une mémoire de souhaits de programmes pour mémoriser des données de programmation,
caractérisé en ce que
- il est prévu un circuit de commande, qui appelle des données à partir de la mémoire de pages de vidéotexte, au moyen d'une sélection correspondante d'adresses de telle sorte que les données de vidéotexte, qui correspondent aux différentes émissions de télévision, sont sélectionnées de façon automatique et individuellement successivement pour l'émission, et
- les données de vidéotexte de l'émission individuelle de télévision, sélectionnée respectivement à partir de la page d'annonces de programme mémorisée temporairement, peuvent étre représentées, d'une manière rehaussée du point de vue optique, pendant une durée de l'ordre de plusieurs secondes, et sans interruption d'une émission de télévision en cours, sur une unité d'affichage.

2. Dispositif pour programmer un magnétoscope, comportant
- une unité de commande pour introduire des instructions de commande,
- un décodeur de vidéotexte pour séparer, d'un signal d'émission de télévision, les données de vidéotexte contenues dans une page d'annonce de programme et correspondant à plusieurs émissions de télévision,
- une mémoire de pages de vidéotexte pour mémoriser temporairement les données indiquées de vidéotexte, et
- une mémoire de souhaits de programmes pour mémoriser des données de programmation,
caractérisé en ce que
- il est prévu un circuit de commande, qui appelle des données à partir de la mémoire de pages de vidéotexte, au moyen d'une sélection correspondante d'adresses de telle sorte que les données de vidéotexte, qui correspondent à des émissions individuelles de télévision, sont sélectionnées individuellement successivement pour l'émission, sous la commande de l'unité de commande, et
- les données de vidéotexte de l'émission individuelle de télévision, sélectionnée respectivement à partir de la page d'annonces de programme mémorisée temporairement, peuvent ètre représentées, d'une manière rehaussée du point de vue optique et sans interruption d'une émission de télévision en cours, sur une unité d'affichage.

3. Dispositif selon la revendication 1 ou 2, caractérisé en ce que l'unité d'affichage est l'écran d'un récepteur de télévision raccordé au magnétoscope, et la représentation, rehaussée du point de vue optique, des données de vidéotexte s'effectue sur une ligne d'écriture, insérée dans une mémoire de télévision, au niveau du bord inférieur de l'écran.

4. Dispositif selon la revendication 1 ou 2, caractérisé en ce que l'unité d'affichage est un dispositif d'affichage alphanumérique intégré dans le boîtier du magnétoscope.

5. Dispositif selon la revendication 1 ou 2, caractérisé en ce que l'unité d'affichage est un écran à cristal liquide, qui est fixé au boîtier du magnétoscope.

6. Dispositif selon la revendication 1 ou 2, caractérisé en ce que les données de vidéotexte sont transmises par un émetteur à infrarouge du magnétoscope à un récepteur à infrarouge du générateur de télécommande du magnétoscope et sont représentées sur un dispositif d'affichage alphanumérique intégré dans le boîtier du générateur de télécommande.

7. Dispositif selon une ou plusieurs des revendications précédentes, caractérisé par le fait que les données de vidéotexte, qui sont représentées sur l'unité d'affichage, sont représentées avec un clignotement.

8. Dispositif selon une ou plusieurs des revendications précédentes, caractérisé en ce que la mémoire de pages de vidéotexte est une mémoire à plusieurs pages, dans laquelle, après le raccordement du magnétoscope à une tension d'alimentation, toutes les pages de vidéotexte, qui contiennent une annonce de programme, sont mémorisées automatiquement.
